# EUROPÄISCHE PATENTSCHRIFT

(11) **EP 2 409 323 B1**
(45) Veröffentlichungstag und Bekanntmachung des Hinweises auf die Patenterteilung: **15.07.2020**
(21) Anmeldenummer: 10714596.3
(22) Anmeldetag: 18.03.2010
(51) Int. Cl.: H01L 21/60, H01L 23/485

(54) **VERFAHREN ZUR HERSTELLUNG EINER METALLISIERUNG MIT MEHRFACH ALTERNIERENDEN NI- UND AU-METALLISIERUNGSSCHICHTEN AUF MINDESTENS EINEM KONTAKTPAD AUF EINEM HALBLEITERWAFER**
METHOD FOR PRODUCING A METALLIZATION WITH MULTIPLE ALTERNATING NI AND AU METALLISATION LAYERS ON AT LEAST ONE CONTACT PAD ON A SEMICONDUCTOR WAFER
PROCÉDÉ DE FABRICATION D'UNE MÉTALLISATION AVEC MULTIPLES COUCHES ALTERNANTES EN NI ET AU SUR AU MOINS UN PLOT DE CONNEXION SUR UNE TRANCHE SEMI-CONDUCTRICE

(30) Priorität: 19.03.2009 DE 102009013921
(43) Veröffentlichungstag der Anmeldung: 25.01.2012
(73) Patentinhaber: Forschungsverbund Berlin E.V., 12489 Berlin (DE)
(72) Erfinder: SIDOROV, Victor, 12157 Berlin (DE); ZHYTNYTSKA, Rimma, 10243 Berlin (DE); WUERFL, Joachim, 15738 Zeuthen (DE)
(74) Vertreter: Gulde & Partner
(86) Internationale Anmeldenummer: PCT/EP2010/053553
(87) Internationale Veröffentlichungsnummer: WO 2010/106144

(56) Entgegenhaltungen:
- DE-A1- 1 439 527
- DE-T2- 69 014 871
- JP-A- 10 163 590
- JP-A- 2006 019 550
- US-A1- 2007 045 848
- US-A1- 2009 021 109

## Beschreibung

Die vorliegende Erfindung betrifft ein Verfahren zur Herstellung einer Metallisierung für mindestens ein Kontaktpad mit den im Anspruch 1 genannten Merkmalen, insbesondere betrifft die vorliegende Erfindung eine verbesserte Technologie zur Herstellung von Kontaktflächen (Kontaktpads) mit einer Metallisierung, auch sog. under bump metallization (UBM) zur elektrischen Verbindung zwischen Halbleiterstrukturen und einem weiteren Verbindungspartner.

Unter der Flip-Chip-Montage (auch Wende-Montage) wird ein Verfahren zur Kontaktierung von Kontaktpads ungehäuster Halbleiter-Chips (auch Wafer, Halbleiterwafer) mittels Kontaktierhügel - sogenannten "Bumps" verstanden. Die Flip-Chip-Technologie wird z.B. bei der Herstellung komplexer Mikroprozessoren verwendet. Bei der Flip-Chip-Montage wird der Chip direkt, ohne weitere Anschlussdrähte, mit der aktiven Kontaktierungsseite nach unten - zum Schaltungsträger hin - montiert. Dies führt zu besonders geringen Abmessungen des Gehäuses und kurzen Leiterlängen. Bei sehr komplexen Schaltkreisen bietet diese Technologie oft die einzige sinnvolle Verbindungsmöglichkeit an, weil zum Teil mehrere tausend Kontakte realisiert werden müssen. So kann die gesamte Fläche des Halbleiter-Chips zur Kontaktierung genutzt werden. Bei der Flip-Chip-Bondtechnik erfolgt die Verbindung aller Kontakte gleichzeitig.

Bei der Flip-Chip-Montage wird ein Metall oder Metallgemisch, das Lot, auf den Halbleiterchip oder Wafer oder eine Leiterplatte abgeschieden. Dadurch entstehen tausende mit je nach Platzierungsverfahren zylindrischen oder kugelförmigen Lotkörpern. Diese Lotkörper befinden sich jeweils exakt auf den Kontaktpunkten, welche die Verbindung zu den Schaltungsstrukturen in den tieferen Schichten des Wafers (Halbleiter-Chips) herstellen. Die Lotkörper werden anschließend zu kleinen Kugeln im Reflowverfahren umgeschmolzen, wobei eine gut haftende, elektrisch gut leitfähige Verbindung zwischen dem Lotkörper und der chipseitigen Metallisierung (Under bump metallization) entsteht und ein eutektischer Lotkörper eine quasi halbkugelförmige Oberfläche erhält. Diese Lotkugeln werden auch "Bumps" genannt.

Zwischen Kontaktierhügel (Bump) und Kontaktpad des Halbleiter-Chips wird häufig eine Metallisierung (sog. "under bump metallization") verwendet, die die mechanische

Belastbarkeit der Verbindung zwischen Bump und Kontaktpad erhöht. Weiterhin erfüllt die Metallisierung häufig die Aufgabe, die Diffusion von Metallatomen des Kontaktpads in den Bump zu unterbinden, was anderenfalls zu einer Destabilisierung der Verbindung führen würden.

Eine weitere Methode, um einen Wafer mit "Bumps" zu versehen, ist der Schablonendruck. Der Wafer wird, nachdem er mittels Galvanik eine lötbare Oberfläche an den Pads erhalten hat, in einem Schablonendrucker mit Lotpaste bedruckt. Danach wird der Wafer auch hier einem Reflowprozess unterzogen, die Lotpaste schmilzt und es entstehen Bumps. Anschließend kann der Wafer gereinigt werden, um überflüssige Flussmittelreste zu entfernen, falls dies notwendig sein sollte.

Es ist bekannt, die Metallisierung durch vollflächige Abscheidung einer Diffusionsbarriere mittels Sputtern, anschließendem Sputtern einer dünnen Startschicht für einen nachfolgenden galvanischen Prozess, lithografische Strukturierung (positiv) und galvanische Abscheidung einer 5-10 µm dicken UBM-Schicht herzustellen. Danach erfolgt eine Ätzung der Diffusionsbarriere und der Startschicht.

Alternativ ist zur Herstellung einer Metallisierung die Verwendung einer außenstromlosen Abscheidung bekannt. In diesem Fall wird auf einem Al-Pad nach einer entsprechenden Vorbehandlung (z.B. Zinkatbehandlung) stromlos Nickel-Phosphor und danach stromlos Gold in entsprechenden chemischen Bädern abgeschieden.

Die Standardtechnologie für die Montage der (regelmäßig zinnhaltigen) Flip-Chip Lot-Bumps erfordert eine einige Mikrometer dicke Nickelschicht als UBM, die notwendig ist, um den Verbrauch von Nickel infolge der Bildung einer NiSn-IMC (intermetallic compound), z.B. Ni₃Sn₄, während des Lötprozesses zu kompensieren. Eine solche einige Mikrometer dicke Nickelschicht wird, wie bereits näher beschrieben, herkömmlicherweise mittels galvanischer oder stromloser Abscheidung hergestellt. Eine vollständige Trockenabscheidung (Sputtern/Bedampfen) einer Nickelschicht mit einer Dicke im Mikrometerbereich ist jedoch nicht möglich, da eine solche Schicht zu einer hohen intrinsischen mechanischen Spannung führt und daher eine zu geringe Adhäsion aufweist.

DE 103 22 135 A1 beschreibt ein Bauelement mit einer Lötverbindung zwischen einem ersten Teilkörper mit einer ersten flächigen Metallisierung und einem zweiten Teilkörper mit einer zweiten flächigen Metallisierung, wobei die Lötverbindung einen Lotkörper aus einem aufschmelzbaren Lot umfasst, bei dem zumindest eine aus erster und zweiter flächiger Metallisierung auf der zum Lotkörper weisenden Oberfläche eine nanokristalline Schicht umfasst.

US 2006/0284313 A1 verwendet als under bump metallization ein Material mit Formgedächtnis, das aus einer Legierung von Titan und Nickel bestehen kann.

Nachteilig an den vorgenannten Technologien zur Herstellung einer Metallisierung (UBM) für ein Kontaktpad eines Halbleiter-Chips ist die Verwendung nasschemischer Prozesse, die in vielen Fällen mit Verwendung toxischer oder zumindest potentiell korrosiver Bäder (z.B. Cyanidbad bei Au-Abscheidung) verbunden sind. Weiterhin kann die stromlose Abscheidung auf III/V-Halbleitern in Abhängigkeit von der aktuellen Gestaltung der Oberfläche zu Wildabscheidungen führen.

US 2007/0045848 A1 beschreibt eine Waferstruktur mit einem Halbleitersubstrat, einer Anzahl von UBM-Schichten und einer Anzahl von Bumps, wobei die UBM-Schicht eine Schichtstruktur zweier mehrfach alternierender Ni- und Cu-Metallisierungsschichten aufweist. DE 1 439 527 A1 offenbart ein Verfahren zum Kontaktieren von Halbleiteranordnungen und betrifft Metall-Plattierungskontakte mit mehrfach alternierenden, stromlos plattierten Au- und Ni-Schichten. JPH 10 163 590 A betrifft ein Verfahren zum Formen eines Stapels von zweimal alternierenden, elektroplattierten Au- und Ni-Schichten für die C-4-Dünnfilmmetallurgie.

Es ist daher Aufgabe der vorliegenden Erfindung, ein Verfahren zur Herstellung eines Halbleiterwafers mit einer UBM-Metallisierung anzugeben, die einerseits mittels physikalischer Gasphasenabscheidung (Trockenabscheidung) hergestellt wird und andererseits eine ausreichend hohe Adhäsion eines Lot-Bumps gewährleistet.

Diese Aufgaben werden erfindungsgemäß durch ein Verfahren zur Herstellung eines Halbleiterwafers mit den im Patentanspruch 1 genannten Merkmalen gelöst. Bevorzugte Ausgestaltungen der Erfindung sind in den Unteransprüchen enthalten.

Das erfindungsgemäße Verfahren zur Herstellung einer Metallisierung (UBM) für mindestens ein Kontaktpad weist folgende Verfahrensschritte auf: Aufbringen mindestens eines Kontaktpads auf einen Halbleiterwafer, Aufbringen einer Barriereschicht auf die Oberseite des mindestens einen Kontaktpads, Aufbringen einer Metallisierung auf die Oberseite der Barriereschicht, wobei die Barriereschicht und die Metallisierung (und vorzugsweise auch das Kontaktpad) mittels physikalischer Gasphasenabscheidung (physical vapour deposition, nachfolgend auch als PVD bezeichnet) aufgebracht werden und die Metallisierung als Schichtstruktur zweier, mehrfach alternierender Metallisierungsschichten ausgebildet wird, wobei die erste Metallisierungsschicht aus Nickel und die zweite Metallisierungsschicht aus Gold ausgebildet wird, die erste Metallisierungsschicht mit einer Schichtdicke kleiner als 100 nm ausgebildet wird, die zweite Metallisierungsschicht mit einer Schichtdicke zwischen 30 nm und 50 nm ausgebildet wird und die Summe der Schichtdicken der ersten Metallisierungsschichten größer als 1 µm beträgt.

Die Erfindung ermöglicht damit die Herstellung einer Ni-basierten UBM ausschließlich mittels PVD-Verfahren (vorzugsweise Sputtern und Aufdampfen). Das Problem der hohen intrinsischen Spannungen von Ni-Schichten bei PVD-Abscheidungen wird dadurch gelöst, dass nach der Abscheidung einer vergleichsweise dünnen Ni-Schicht (Schichtdicke kleiner als 100 nm) eine Schicht aus einem duktilen, elektrisch leitfähigen Material, nämlich Gold, folgt. Diese beiden Schritte (Aufbringen einer Ni-Schicht und einer Schicht aus einem duktilen, elektrisch leitfähigen Material, nämlich Gold) werden erfindungsgemäß mehrmals wiederholt, was zu einem Stapel alternierender Ni-Schichten und Schichten aus dem duktilen, elektrisch leitfähigen Material, nämlich Gold, mit einer Gesamtdicke von einigen Mikrometern (größer 1 µm, noch bevorzugter größer 2 µm) führt. Dieses Verfahren ermöglicht vorteilhafterweise die Herstellung einer mechanisch und elektrisch zuverlässigen UBM ohne Verwendung nasschemischer Prozesse.

In einem zum beanspruchten Gegenstand nicht gehörenden Beispiel kann auch anstatt Ni eine Ni-Legierung benutzt werden, die vorzugsweise mindestens 10% Nickel (bezogen auf die Masse) enthält.

Die Barriereschicht ist vorzugsweise ausgebildet um die Diffusion von Metallatomen aus dem Kontaktpad in die UBM und eventuell weiter in das Lot-Bump zu verhindern. Die Barriereschicht besteht vorzugsweise aus einer amorphen oder feinkristallinen mit dekorierten Korngrenzen versehenen Metallisierung oder intermetallischen Verbindung , die chemisch nicht mit der Metallisierung des Kontaktpads oder der UBM reagiert. Es kommen hier vorzugsweise intermetallische Verbindungen wie WSiN, TiW, TiMo oder andere in Frage. Die Barriereschicht weist vorzugsweise eine Schichtdicke zwischen 50 nm und 1 µm auf.

Die erste Metallisierungsschicht besteht erfindungsgemäß aus Ni oder in einem zum beanspruchten Gegenstand nicht gehörenden Beispiel aus einer Ni-Legierung (z.B. NiV). Diese Metallisierung ist in metallurgischer Hinsicht verantwortlich für die elektrischen und mechanischen Eigenschaften der Bump-UBM Verbindung und muss an die Metallurgie des Bumps selbst angepasst sein. Für PbSn Bumps ist beispielsweise Ni oder, in einem zum beanspruchten Gegenstand nicht gehörenden Beispiel, geeignet. Die erste aus Ni weist eine Dicke kleiner als 100 nm auf.

Da Metalle entsprechend der ersten Metallisierung, in der Regel eine sehr hohe mechanische Verspannung aufweisen, wenn sie im physikalischen Abscheidungsverfahren aufgebracht werden, muss alternierend eine zweite Metallisierung mit eingebaut werden, die diese Verspannungen aufnehmen kann, die Metallurgie und elektrische Leitfähigkeit des Bump-UBM-Systems nicht negativ beeinflusst. Die zweite Metallisierungsschicht besteht erfindungsgemäß aus Gold. In nicht zum beanspruchten Gegenstand gehörenden Beispielen kann die zweite Metallisierungsschicht aus einem Metall aus der Gruppe Silber, Platin, Kupfer, Eisen, Aluminium, Zink, Zinn und Blei, einer Mischung mindestens zwei Metalle aus der Gruppe Gold, Silber, Platin, Kupfer, Eisen, Aluminium, Zink, Zinn und Blei oder einer Legierung der zuletzt genannten Metalle bestehen, wobei dann die zweite Metallisierungsschicht vorzugsweise aus einem Material mit einer Duktilität, die mindestens 60% der Duktilität von Gold entspricht, und einer elektrischen Leitfähigkeit, die mindestens 60% der elektrischen Leitfähigkeit von Gold entspricht, und vorzugsweise mit einer Schichtdicke zwischen 10-100 nm ausgebildet wird.

Vorzugsweise wird auch das Kontaktpad mittels physikalischer Abscheidung aufgebracht. Vorzugsweise werden das Kontaktpad durch Aufdampfen und die Barriereschicht durch Sputtern aufgebracht.

Die erste Metallisierungsschicht aus Nickel wird mit einer Schichtdicke kleiner als 100 nm ausgebildet. Die zweite Metallisierungsschicht aus Gold wird mit einer Schichtdicke zwischen 30-50 nm ausgebildet.

Vorzugsweise wird das Kontaktpad mit einer Fläche zwischen 1 µm² und 0,20 m² (entspricht 450 mm Waferdurchmesser), die erste Metallisierungsschicht mit einer Fläche zwischen 1 µm² und 0,20 m² und die zweite Metallisierungsschicht mit einer Fläche zwischen 1 µm² und 0,20m² ausgebildet, besonders bevorzugt ist jeweils eine Fläche zwischen 0,01 und 0,1 mm².

Erfindungsgemäß kann ein zinnhaltiges Lot-Bump zur späteren Kontaktierung mittels Flip-Chip-Montage verwendet werden.

Der Halbleiterwafer weist mindestens ein auf dem Halbleiterwafer angeordnetes Kontaktpad (vorzugsweise mehrere 1000 Kontaktpads auf, wobei die Kontaktpads vorzugsweise die elektrische Verbindung des einen mikroelektronischen Schaltkreis aufweisenden Halbleiterwafers nach außen realisieren) auf, wobei auf der Oberseite des mindestens einen Kontaktpads eine Barriereschicht vorgesehen ist und auf der Oberseite der Barriereschicht eine Metallisierungsstruktur angeordnet ist, wobei die Metallisierungsstruktur erfindungsgemäß zwei, mehrfach alternierende Metallisierungsschichten aufweist, wobei die erste Metallisierungsschicht aus Nickel mit einer Schichtdicke kleiner als 100 nm und die zweite Metallisierungsschicht aus einem von Nickel verschiedenen, elektrisch leitfähigen, duktiler Material, nämlich Gold, ausgebildet ist. Vorzugsweise bedeckt die Barriereschicht das auf dem Wafer befindliche Kontaktpad vollständig. Vorzugsweise bedeckt die Metallisierungsstruktur mindestens 50% der Oberfläche des Kontaktpads (Barriereschicht dazwischen) - besonders bevorzugt mindestens 80% der Oberfläche des Kontaktpads.

Die Anzahl der aufeinanderfolgenden Stapel aus erster Metallisierungsschicht und zweiter Metallisierungsschicht ist derart gewählt, dass die Summe der Schichtdicken der ersten Metallisierungsschichten größer als 1 µm (bevorzugter größer als 3 µm) beträgt.

Vorzugsweise weist der Halbleiterwafer einen Halbleiter-Chip auf und/oder der Halbleiterwafer weist mindestens einen mikroelektronischen Schaltkreis auf.

Vorzugsweise wird der Halbleiterwafers mit den o.g. Merkmalen zur Verbindung des Halbleiterwafers mit einem Schaltungsträger mittels der Flip-Chip-Montage verwendet.

Die Erfindung wird nachfolgend anhand von in den Figuren dargestellten Ausführungsbeispielen näher erläutert.

Es zeigen:
- Fig. 1: einen Wafer mit einer erfindungsgemäß hergestellten Metallisierungsstruktur in schematischer, geschnittener Darstellung,

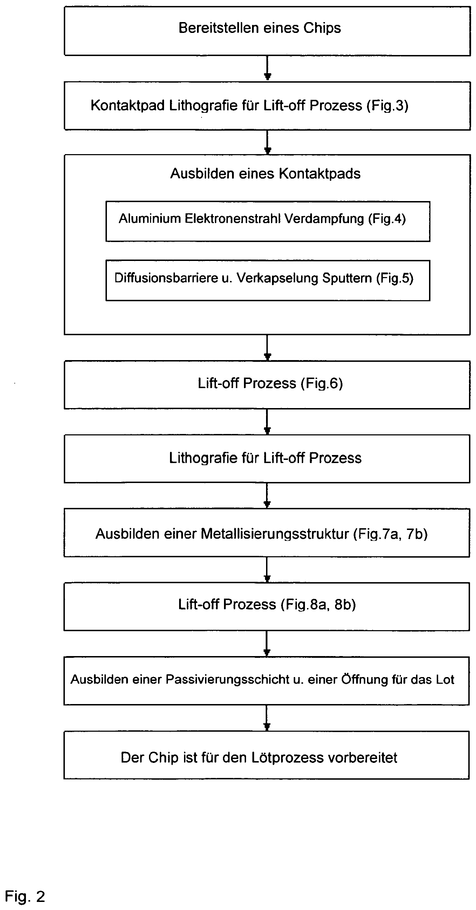

- Fig. 2: ein Flussdiagramm mit den einzelnen Prozessschritten einer bevorzugten Ausführungsvariante des erfindungsgemäßen Verfahrens zur Herstellung eines Wafers mit erfindungsgemäßer Metallisierungsstruktur, und
- Fig. 3 bis Fig. 8b: die einzelnen Verfahrensschritte einer bevorzugten Ausführungsvariante des erfindungsgemäßen Verfahrens.

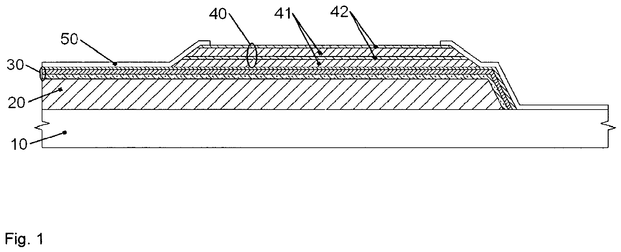

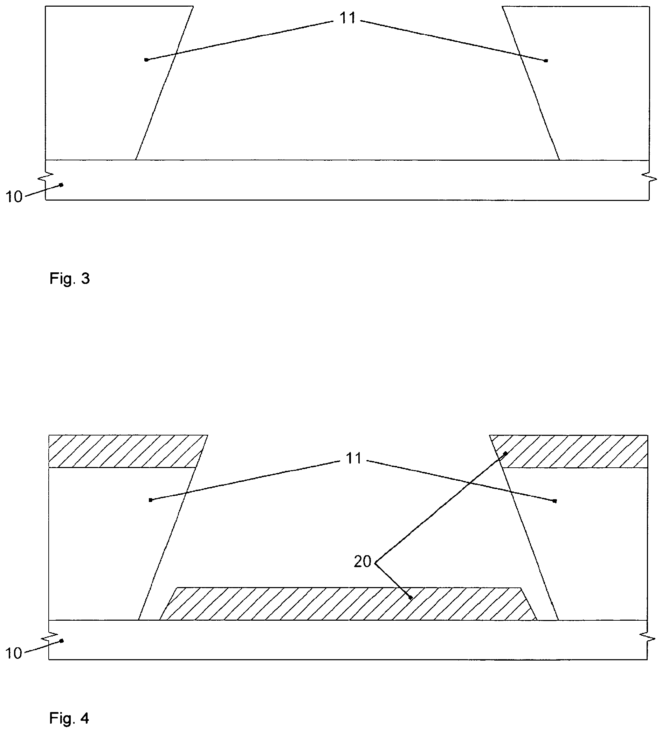

Fig. 1 zeigt einen Wafer mit einer erfindungsgemäß hergestellten Metallisierungsstruktur in schematischer, geschnittener Darstellung. Der Wafer 10 kann beispielsweise einen Chip oder eine elektronische Schaltung umfassen. Um diese elektronische Schaltung des Wafers 10 (auch als Substrat oder Halbleiterwafer bezeichnet) mit einem Schaltungsträger zu kontaktieren, weist der Wafer 10 eine Vielzahl von Kontaktpads 20 auf, über die die elektronische Schaltung des Wafers 10 mit dem Schaltungsträger elektrische Signale austauscht (kommuniziert). Die Kontaktpads 20 können beispielsweise aus duktilem Material wie AI, Cu oder Au durch Aufdampfen (e-beam evaporation) unter Zuhilfenahme einer Maske 11 aufgebracht werden (Fig. 3 und 4).

Um das Verbinden von Wafer 10 und dem (hier nicht dargestellten) Schaltungsträger mittels Flip-Chip-Montage zu ermöglichen, wird zwischen den Kontaktpads 20 und den Kontakten des Schaltungsträgers ein (hier nicht dargestelltes) Lot-Bump aufgebracht und nachfolgend werden Wafer 10 und Schaltungsträger dauerhaft miteinander verlötet.

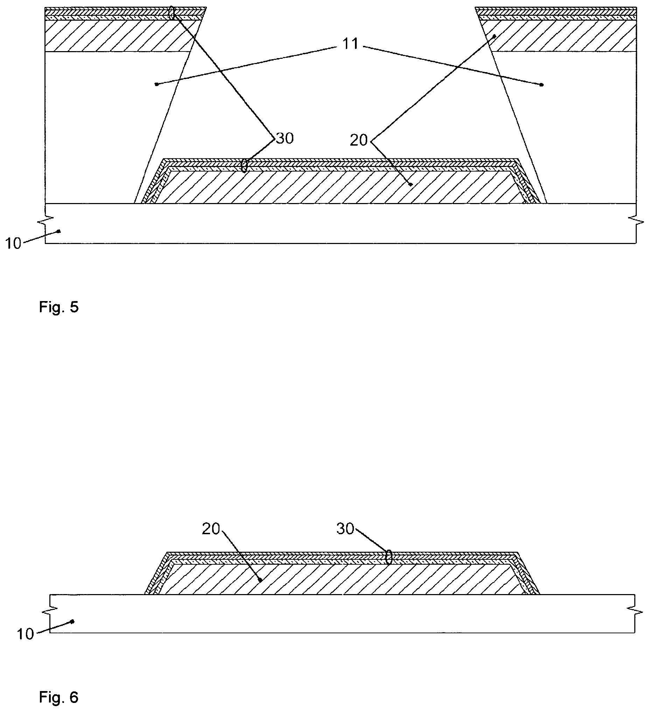

Um eine mechanisch und elektrisch zuverlässige Verbindung des Lot-Bump mit dem Kontaktpad 20 ohne Verwendung nasschemischer Prozesse zu realisieren, wird auf das Kontaktpad 20 zunächst eine Barriereschicht 30 mittels Sputtern aufgebracht. Dies kann wie in Fig. 5 und 6 dargestellt durch dieselbe Maske 11 wie beim Aufbringen der Pads 20 erfolgen. In diesem Fall weist das Verfahren den zusätzlichen Vorteil auf, dass die Padmetallisierung komplett von einer Diffusionsbarriere umgeben ist und daher zusätzlich eine höhere Elektromigrationsfestigkeit bei hohen Stromdichten in der Metallisierung zeigt Vorzugsweise werden für die Kontaktpads 20 und die Barriereschicht 30 grundlegend verschiedene Abscheidungseigenschaften ausgenutzt: das Aufdampfen der Kontaktpads 20 weist ein isotropes und das Sputtern der Barriereschicht 30 ein anisotropes Verhalten auf. Durch Verwendung einer lithografischen Maske 11 mit Unterschnitt (Negativresist) ist eine Kombination beider Prozessschritte mit nur einer Maske 11 möglich. Dies ermöglicht die Herstellung einer Kontaktfläche 20 mit definierter Geometrie und anschließend gleichmäßiger Bedeckung durch das Sputtern der Diffusionsbarriere 30 (Fig. 3-6).

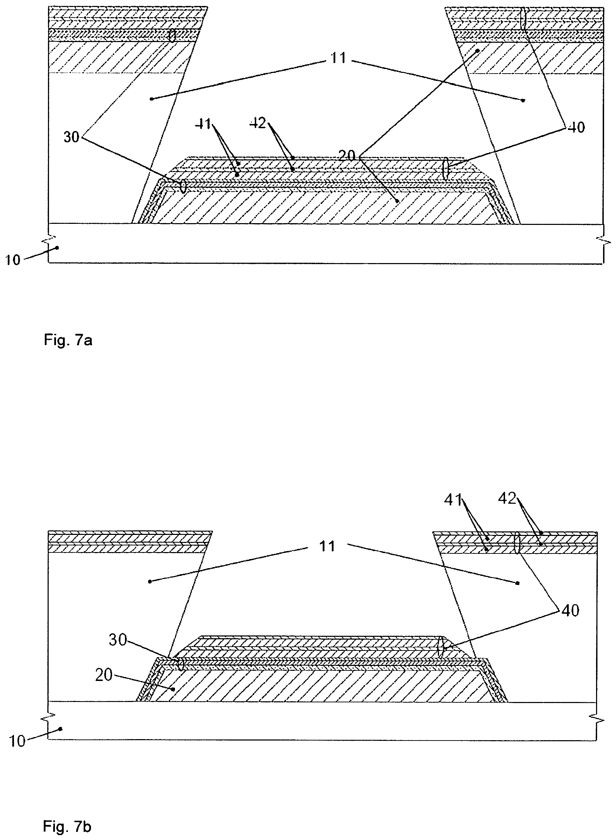

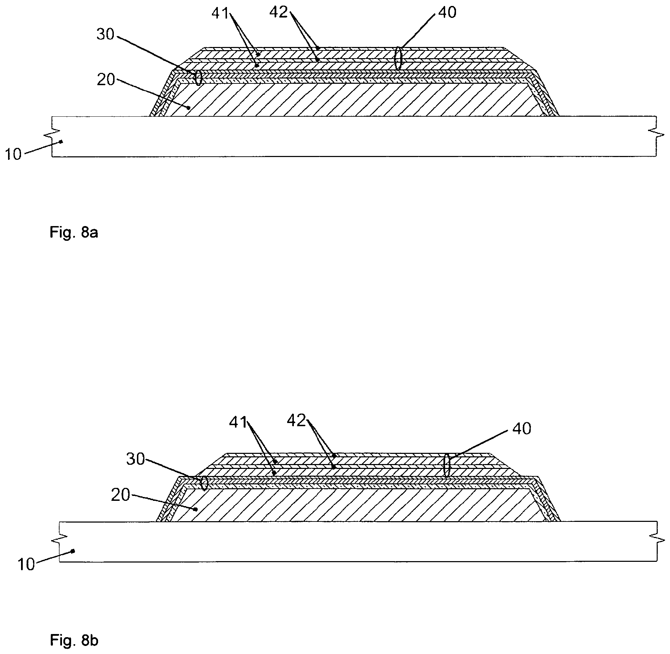

Fig. 7a zeigt die Abscheidung alternierender Metallschichten 41, 42 hergestellt beispielsweise durch Elektronenstrahlverdampfen. Die Metallisierungsstruktur 40 bedeckt die gesamte Kontaktfläche 20 durch Verwendung derselben Maske 11 wie bei der Abscheidung des Kontaktpads 20. Alternativ ist es möglich, die Metallisierungsstruktur 40 nur auf einem Teil der Kontaktfläche des Kontaktpads 20 (mit Barriereschicht 30 dazwischen) abzuscheiden, wobei hierfür eine zusätzliche Maske benötigt wird (Fig. 7b). Die resultierenden Strukturen nach Abscheidung der alternierenden Schichtenfolge 41, 42 ist in den Fig. 8a und 8b gezeigt.

Die Standardtechnologie für die Montage der (regelmäßig zinnhaltigen) Flip-Chip Lot-Bumps erfordert eine einige Mikrometer dicke Nickelschicht, die notwendig ist, um den Verbrauch von Nickel infolge der Bildung einer NiSn-IMC (intermetallic compound) während des Lötprozesses zu kompensieren.

Eine vollständige Trockenabscheidung (Sputtern/Bedampfen) einer Nickelschicht mit einer Dicke im Mikrometerbereich ist jedoch nicht möglich, da eine solche Schicht eine zu hohe intrinsische mechanische Spannung und daher eine zu geringe Adhäsion aufweist.

Das Problem der hohen intrinsischen Spannungen von Ni-Schichten bei PVD-Abscheidungen wird erfindungsgemäß dadurch gelöst, dass nach der Abscheidung einer dünnen Ni-Schicht (Schichtdicke kleiner als 100 nm) eine Schicht aus einem duktilen, elektrisch leitfähigen Material, nämlich Gold mit einer Schichtdicke von 30-50 nm, folgt.

Diese beiden Schritte (Aufbringen einer Ni-Schicht und einer Schicht aus einem duktilen, elektrisch leitfähigen Material) werden erfindungsgemäß mehrmals wiederholt, was zu einem Stapel alternierender Ni-Schichten und Schichten aus dem duktilen, elektrisch leitfähigen Material mit einer Gesamtdicke von einigen Mikrometern (größer 1 µm, noch bevorzugter größer 2 µm) führt.

Die Unterbrechung der Ni-Schicht 41 durch die Au-Schicht 42 führt dazu, dass die nachfolgende Ni-Schicht 41 keine bzw. eine erheblich reduzierte anfängliche mechanische Spannung aufweist. Dieses Verfahren ermöglicht vorteilhafterweise die Herstellung einer mechanisch und elektrisch zuverlässigen UBM ohne Verwendung nasschemischer Prozesse.

Nach Abscheidung der Metallisierungsstruktur 40 wird vorzugsweise eine Passivierungsschicht 50 aufgebracht (Fig. 1), die die seitlichen Bereiche des Schichtenstapels 41, 42 abdeckt und die Kontaktfläche das (hier nicht dargestellte) Lot-Bump definiert.

### Bezugszeichenliste

- 10: Substrat
- 11: Maske
- 20: Kontaktpad
- 30: Diffusionsbarriere
- 40: Metallisierungsstruktur
- 41: Nickelschicht
- 42: Goldschicht
- 50: Passivierungsschicht

## Patentansprüche

1. Verfahren zur Herstellung einer Metallisierung (40) für mindestens ein Kontaktpad (20) mit folgenden Verfahrensschritten:
- Aufbringen mindestens eines Kontaktpads (20) auf einen Halbleiterwafer (10),
- Aufbringen einer Barriereschicht (30) auf die Oberseite des mindestens einen Kontaktpads (20),
- Aufbringen einer Metallisierung (40) auf die Oberseite der Barriereschicht (30), wobei die Metallisierung (40) als Schichtstruktur zweier, mehrfach alternierender Metallisierungsschichten (41, 42) ausgebildet wird, wobei die erste Metallisierungsschicht (41) aus Nickel mit einer Schichtdicke kleiner als 100 nm und die zweite Metallisierungsschicht (42) mit einer Schichtdicke zwischen 30 nm und 50 nm ausgebildet wird,
**dadurch gekennzeichnet, dass**
die Barriereschicht (30) und die Metallisierung (40) mittels physikalischer Gasphasenabscheidung aufgebracht werden, die zweite Metallisierungsschicht (42) aus Gold ausgebildet wird und die Summe der Schichtdicken der ersten Metallisierungsschichten (41) größer als 1 µm beträgt.

2. Verfahren nach Anspruch 1,
**dadurch gekennzeichnet, dass**
das Kontaktpad (20) mittels physikalischer Abscheidung aufgebracht wird.

3. Verfahren nach Anspruch 2,
**dadurch gekennzeichnet, dass**
das Kontaktpad (20) und die Barriereschicht (30) durch Aufdampfen oder Sputtern aufgebracht werden.

## Claims

1. A method for producing a metallization (40) for at least one contact pad (20) having the following method steps:
- applying at least one contact pad (20) onto a semiconductor wafer (10),
- applying a barrier layer (30) onto the top side of the at least one contact pad (20),
- applying a metallization (40) onto the top side of the barrier layer (30), wherein the metallization (40) is formed as a layer structure of two multiple alternating metallization layers (41, 42), wherein the first metallization layer (41) made of nickel is formed with a layer thickness smaller than 100 nm and the second metallization layer (42) is formed with a layer thickness between 30 nm and 50 nm,
**characterized in that**
the barrier layer (30) and the metallization (40) are applied by means of physical vapor phase separation,
the second metallization layer (42) is formed from gold, and the sum of the layer thicknesses of the first metallization layers (41) is larger than 1 µm.

2. The method according to Claim 1,
**characterized in that**
the contact pad (20) is applied by means of physical deposition.

3. The method according to Claim 2,
**characterized in that**
the contact pad (20) and the barrier layer (30) are applied by vapor deposition or sputtering.

## Revendications

1. Procédé de fabrication d'une métallisation (40) pour au moins un plot de connexion (20) comprenant les étapes de procédé suivantes :
- l'application d'au moins un plot de connexion (20) sur une tranche semi-conductrice (10),
- l'application d'une couche de barrière (30) sur le côté supérieur dudit au moins un plot de connexion (20),
- l'application d'une métallisation (40) sur le côté supérieur de la couche de barrière (30),
la métallisation (40) étant configurée sous la forme d'une structure stratifiée de deux couches de métallisation (41, 42), en alternances multiples, la première couche de métallisation (41) étant configurée à base de nickel, avec une épaisseur de couche inférieure à 100 nm, et la deuxième couche de métallisation (42) étant configurée avec une épaisseur de couche comprise entre 30 nm et 50 nm.
**caractérisé en ce que**
la couche de barrière (30) et la métallisation (40) sont appliquées au moyen d'un dépôt physique en phase vapeur,
la deuxième couche de métallisation (42) est configurée à base d'or et la somme des épaisseurs de couche des premières couches de métallisation (41) est supérieure à 1 µm.

2. Procédé selon la revendication 1,
**caractérisé en ce que**
le plot de connexion (20) est appliqué au moyen d'un dépôt physique.

3. Procédé selon la revendication 2,
**caractérisé en ce que**
le plot de connexion (20) et la couche de barrière (20) sont appliqués par évaporation ou pulvérisation.
